(19)

Europäisches
Patentamt
European
Patent Office
Office européen
des brevets

(11)  **EP 2 773 045 B1**

(12)  **EUROPEAN PATENT SPECIFICATION**

(45)  Date of publication and mention
of the grant of the patent:
**13.02.2019   Bulletin 2019/07**

(51)  Int Cl.:
**H03M 1/06** *(2006.01)*      *H03M 1/12* *(2006.01)*

(21)  Application number: **13001057.2**

(22)  Date of filing: **02.03.2013**

(54)  **Process for mismatch correction of the output signal of a time-interleaved analog to digital converter**

Verfahren zur Fehlanpassungskorrektur des Ausgangssisgnals eines zeitverschachtelten
Analog-Digital-Wandlers

Procédé de correction de désadaptation du signal de sortie d'un convertisseur analogique-numérique
à entrelacement temporel

(84)  Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43)  Date of publication of application:
**03.09.2014   Bulletin 2014/36**

(73)  Proprietor: HENSOLDT Sensors GmbH
**82024 Taufkirchen (DE)**

(72)  Inventors:
  • **Singh, Simran**
    **89518 Heidenheim (DE)**
  • **Epp, Michael**
    **87437 Kempten (DE)**
  • **Vallant, Georg J.**
    **89073 Ulm (DE)**
  • **Schlecker, Wolfgang**
    **89607 Emerkingen (DE)**

(74)  Representative: LifeTech IP
**Spies & Behrndt Patentanwälte PartG mbB
Elsenheimerstraße 47a
80687 München (DE)**

(56)  References cited:
  • FU D ET AL: "Calibration of Sample-Time Error in a Two-Channel Time-Interleaved Analog-to-Digital Converter", IEEE TRANSACTIONS ON CIRCUITS AND SYSTEMS PART I: REGULAR PAPERS, IEEE SERVICE CENTER, NEW YORK, NY, US, vol. 51, no. 1, January 2004 (2004-01), pages 130-139, XP011105430, ISSN: 1057-7122, DOI: 10.1109/TCSI.2003.821302
  • SHAFIQ M JAMAL ET AL: "A 10-b 120-Msample/s Time-Interleaved Analog-to-Digital Converter With Digital Background Calibration", IEEE JOURNAL OF SOLID-STATE CIRCUITS, IEEE SERVICE CENTER, PISCATAWAY, NJ, USA, vol. 37, no. 12, December 2002 (2002-12), XP011065900, ISSN: 0018-9200
  • CHI HO LAW ET AL: "A Four-Channel Time-Interleaved ADC With Digital Calibration of Interchannel Timing and Memory Errors", IEEE JOURNAL OF SOLID-STATE CIRCUITS, IEEE SERVICE CENTER, PISCATAWAY, NJ, USA, vol. 43, no. 10, October 2010 (2010-10), pages 2091-2103, XP011318989, ISSN: 0018-9200

## Description

## Technical Background

Since the past few decades signal processing is done in the digital domain with increasing preference instead of the analog domain. This is tied with the fact that digital signal processing (DSP) is more robust, precise, powerful and flexible. The real world is analog and an Analog-to-Digital-Converter (ADC) converts the analog signal to digital form by sampling and quantizing it. The ADC is therefore a key component in communication systems. It has a certain sampling rate and a certain number of bits that determines the resolution of the sampled analog signal.

Continuously developing a single core ADC with higher sampling rate becomes very difficult after a certain point due to technological limitations. Alternatively, M number of ADCs can be operated in parallel to achieve M times higher sampling rate of the single ADC. Each ADC samples the analog signal at a different point in time with a time shift dependent on M. This is known as Time-Interleaved ADC (TI-ADC).

Theoretically any arbitrary number of ADCs can be interleaved to achieve a higher sampling rate while preserving the ADC's effective resolution. However in practice there are factors that prevent this. Each ADC will have a different frequency response, e.g. due to unavoidable manufacturing tolerances, causing the ADCs to have a mismatch to one another. This distorts the signal and restricts the TI-ADC's performance by causing spurs in the spectrum which limit the spurious free dynamic range (SFDR) leading to a loss in the TI-ADC's effective resolution. Fortunately, the TI-ADC's mismatch related effective resolution loss can be mitigated using correction algorithms in the digital domain increasing its performance.

To achieve an even higher TI-ADC performance, it is important to correct the individual ADCs frequency response mismatches (the frequency dependent mismatches). A state-of-the-art publication that addresses adaptive frequency response mismatches correction of 2-channel TI-ADCs is [3]. It can be quoted from the publications [1], [3], [5] that suitable online TI-ADC mismatch identification methods (preferably frequency response mismatch identification) with minimum hardware requirement are of interest and an open challenge.

Some of the referenced patents below describe only the mismatch compensation structure. An example of the compensation structure (US 7,403,875 B2) can be seen in [3]. One referenced patent addresses a general mismatch detection method of M-channel TI-ADCs by using one of the ADCs as reference (US 8,307,284 B2). Another similar patent focuses only on the timing mismatch of M-channel TI-ADCs (US 7,741,982 B2) by selecting one ADC as reference. Two other referenced patents (US 7,978,104 B2 and US 8,009,070 B2) suggest the use of parallel, fixed compensation filters, which are not computed online, requiring matrix inversions, and thus may not be optimal for some ruggedized applications.

One TI-ADC mismatch identification technique ([1], [2], [3], [4]) requires allocating a region in the Nyquist band where only the TI-ADC mismatch spurs exists. Let this be referred to as the Interleaving-Mismatch-Spur-Band (IMSB). The IMSB reduces the effective bandwidth of the TI-ADC but as long as the desired signal components have sufficient contribution into this allocated IMSB, an estimate of the TI-ADC mismatch can be obtained.

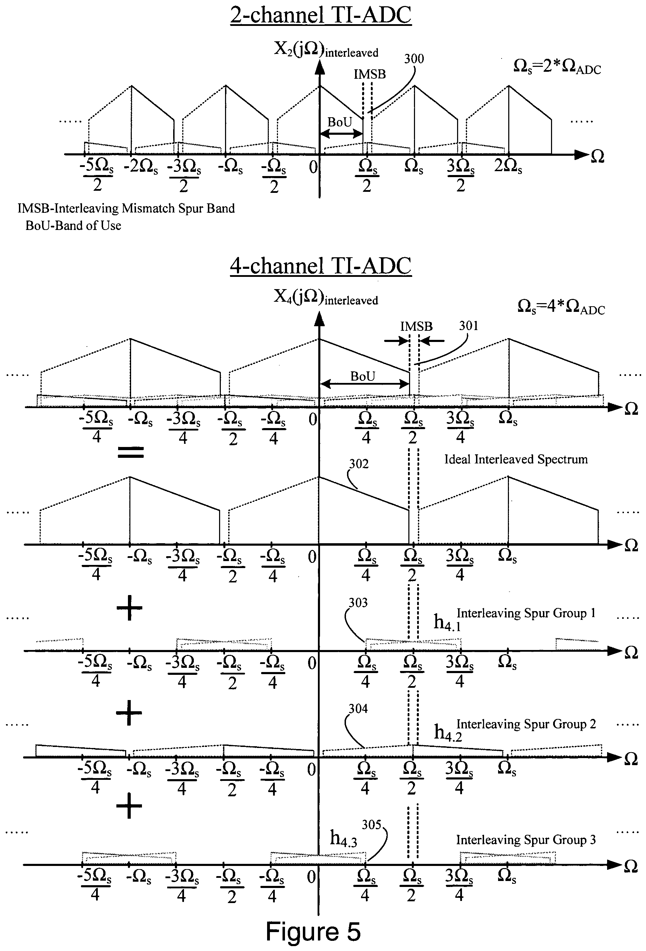

However, as the number of interleaved ADCs increase, allocating a single region for the mismatch identification becomes insufficient. This will be further explained with reference to Figure 5 that shows interleaving mismatch spur bands for mismatch identification of a 2-channel and 4-channel TI-ADC. The IMSB technique works well for a 2-channel TI-ADC case with one clearly defined IMSB 300. However, as a person skilled in the art knows, with increasing number of TI-ADC this method no longer provides an accurate estimate Within the IMSB 301, there is now not only an overlapping of multiple spur groups 303,304,305 present but more importantly because certain interleaving spurs are confined within different regions of the Nyquist zone. For example, in the case of 4-channel TI-ADC, some spurs are confined within the lower half of the 1st Nyquist zone and some in the upper half of the 1st Nyquist zone. As a consequence, allocating just one IMSB region is not enough in this case for the 4-channel TI-ADC mismatch identification as it does capture all the mismatch spurs. This can be overcome by allocating a second IMSB region but it will cause the TI-ADC's usable Nyquist zone to become segmented, which is undesirable.

S. M. Jamal, D. Fu, N. C. J. Chang, P. J. Hurst and S. H. Lewis "A 10-b 120-Msample/s timeinterleaved analog-to-digital converter with digital background calibration", IEEE J. Solid-State Circuits, vol. 37, no. 12, pp.1618 - 1627 2002 deals with the detection of gain and timing mismatch of the 2-channel TI-ADC in the digital domain. The timing mismatch detection is done by aligning the desired signal tone and mismatch spur, done via chopping by multiplying the signal's odd samples with -1, i.e. $(-1)^n$. The input signal tone is located at the same position as the interleaving mismatch spur. This setting is then used to extract the mismatch parameter by a correlation process.

Jamal, S.M.; Fu, D.; Singh, M.P.; Hurst, P.J.; Lewis, S.H. "Calibration of Sample-Time Error in a Two-Channel Time-Interleaved Analog-to-Digital Converter", IEEE Transactions on Circuits and Systems, I Fundamental Theory and Applications, Volume 51, Issue 1, pp.130, 2004, ISSN: 10577122. This paper is a continuation of the previous paper focusing specifically on timing mismatch between the two interleaved ADCs. The correction structure used is essentially the same as in the previous paper, however, there is one module replaced by a Hilbert transform. The Hilbert transform used in this paper is to eliminate the 90 degree phase shift between the timing mismatch spur after the frequency alignment.

The paper C. H. Law, P. J. Hurst and S. H. Lewis "A four-channel time-interleaved ADC with digital calibration of interchannel timing and memory errors", IEEE J. Solid-State Circuits, vol. 45, no. 10, pp.2091- 2103, 2010 extends the method proposed in the two previous papers to the detection of the gain and timing mismatch for the four TI-ADC case.

## Object of the invention

It is an object of the invention to provide a method for an adaptive digital mismatch correction of an M-channel TI-ADC without having to reduce the TI-ADC's usable bandwidth (M being the number of ADCs operated in parallel during the time-interleaved analog to digital conversion). In particular the requirement of allocating an IMSB in the frequency spectrum for the TI-ADC mismatch spurs should be avoided.

## Summary of the Invention

This invention concerns a process according to the independent claim for the adaptive digital mismatch correction of an M-channel TI-ADC. This mismatch mitigation involves two main steps. The first step is the mismatch identification and the second step is the mismatch compensation. This invention is aimed in particular at the identification method. It involves mapping the time interleaved ADC mismatch problem into an IQ imbalance problem for which dedicated solutions are already well established [6].

A person familiar with receiver architectures knows that IQ imbalance is a problem present in the Homodyne Receiver (HMR). The HMR's I- & Q-branch mismatch causes frequency components in I- & Q-branch to differ in magnitude and deviate from the required 90° phase difference. This leads to insufficient conjugate frequency rejection which causes spurs in the spectrum that limits the dynamic range and performance of the HMR. In the IQ imbalance problem, the spurs are located at the conjugate frequency position of the desired signal tone. The presence of a spur at the conjugate frequency location can be detected and measured using statistical properties of the complex signal [6].

According to the invention there is provided a mapping mechanism which converts the TI-ADC problem into an IQ imbalance (cf. IQ mismatch) problem. The TI-ADC spurs are placed at the conjugate frequency location of the desired signal tone via frequency shifting. This allows the TI-ADC problem to be treated as an IQ imbalance problem for the purpose of extracting the mismatch. It offers a novel solution for identifying the TI-ADC mismatch and circumvents the challenges of existing techniques.

The TI-ADC's output signal is real-valued and therefore has a two-sided frequency spectrum. According to the invention an analytical signal which has a one-sided spectrum is generated from this TI-ADC real-valued output. This is done either via e.g. a Hilbert transform or a complex band pass filter and it produces a complex valued signal. A person skilled in the art would know that the required frequency shifting can be easily performed using complex signals.

The analytical signal of the TI-ADC output (the input may be any operational signal) is used to derive various specific mismatch identification signals (MIS). In each generated MIS, one group of the interleaving spurs are placed onto the conjugate frequency position of the desired signal tones. This produces a scenario present in an IQ imbalance system. Now, by measuring statistical properties of the MIS using preferably Higher-order-statistics (HOS) the spur's magnitude and phase information are extracted [6]. Therefore the TI-ADC's spur mismatch parameters are obtained in similar fashion as in the IQ imbalance case.

The next step involves the TI-ADC mismatch compensation. To keep things efficient, the compensation structure is kept as coherent as possible to the mismatch identification structure. The frequency components are first shifted to the spur positions, then filtered (manipulated in magnitude and in phase) so that they match the interleaving spur component. The frequency shifting and filtering operations reconstruct the interleaving mismatch spurs. Once the interleaving spur component has been reconstructed, it is subtracted from the original TI-ADC's output signal. This greatly reduces the TI-ADC's spur level (increasing the SFDR) and recovers the TI-ADC's lost effective resolution.

## Advantages of the Invention

This invention's advantage lies in the M-channel TI-ADC mismatch identification, which is done without having to reduce the TI-ADC's usable bandwidth. E.g. it does not require allocating an IMSB in the frequency spectrum for the TI-ADC mismatch spurs as can be observed in reference publications [1], [2], [3], [6]. It is therefore free of the inherent drawbacks related to this method. That means it does not fail to estimate the interleaving mismatch if the signal sampled by the TI-ADC does not have frequency components whose spurs fall into this allocated IMSB. Since no IMSB is required, the TI-ADC's available bandwidth is not reduced.

It also does not fail in the case of a higher number of TI-ADC where not all the spur can be captured in a single IMSB. A signal tone sampled via M-channel TI-ADC will produce M-1 interleaving mismatch related spurs. Certain interleaving spurs are confined in different regions within the 1st Nyquist zone. In the case of the 4-channel TI-ADC as shown in Figure 5, there is the ideal interleaved spectrum 302 and three distinct interleaving spur groups 303, 304, 305 (the ideal interleaved spectrum 302 and the respective interleaving spur groups 303, 304, 305 are separated to illustrate the position where these components are located). It can be seen from Figure 5 that spur group 305 is confined within the lower half of the 1st Nyquist zone and spur group 303 in the upper half of the 1st Nyquist zone for 4-channel TI-ADC 303. Therefore one IMSB would be required in the lower half of the 1st Nyquist zone and the other in the upper half of the 1st Nyquist zone to get a reference of all interleaving spurs for the mismatch identification process. As a consequence the usable Nyquist zone becomes segmented.

As outlined before, this invention avoids this problem. The idea behind the mismatch identification signals (MIS) of this invention is that a specific IQ imbalance combination pair is created for each interleaving spur. The TI-ADC spurs are placed onto conjugate frequency location of the desired signal tone, as found in the IQ imbalance case. This created conjugate pair can be viewed as an IQ imbalance signal. This signal is fed into the adaptive IQ imbalance correction block, where the interleaving mismatch parameters are extracted using well-known IQ imbalance correction methods. Preferably, HOS algorithms are deployed to extract the TI-ADC mismatch.

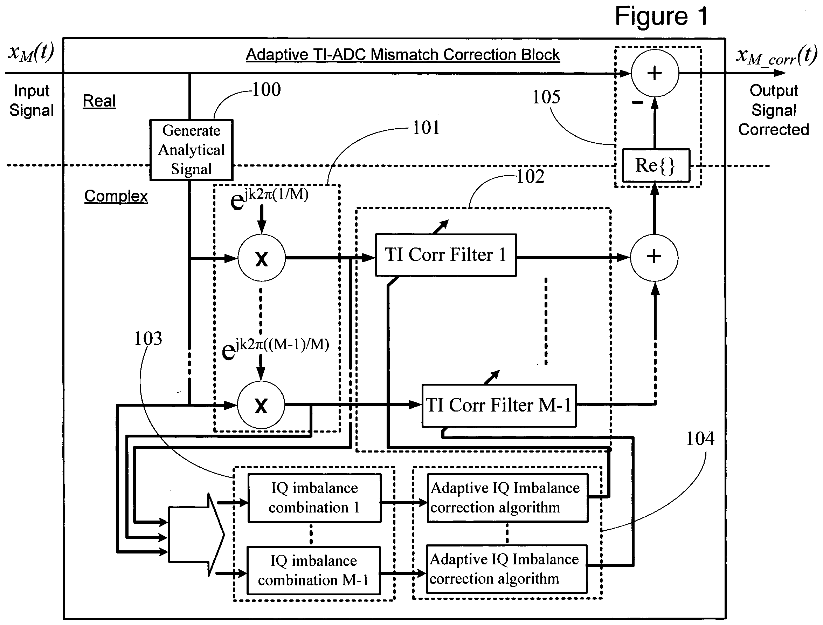

Another advantage of this invention is the synergy between the identification (Figure 1, blocks 101,103,104) and compensation structure (Figure 1, blocks 100,101,102, 105). This invention offers a complete package of TI-ADC mismatch mitigation. The signals generated for the compensation structure are also used for the identification process thus increasing the efficiency and keeping the required computations to a minimum. Therefore the invention is also attractive for an on-chip implementation.

This invention creates a bridge between TI-ADC and IQ imbalance mismatch correction field of work. It opens up new possibilities for the mismatch identification (via MIS) and circumvents the challenges of existing methods.

**Brief Decription of the Drawings**

The invention is explained in greater detail with reference to figures, which illustrate:

Figure 1     an adaptive M-channel TI-ADC mismatch correction block according to the invention;

Figure 2     an M-channel TI-ADC mismatch correction flow chart according to the invention;

Figure 3     a 2-channel TI-ADC error correction process using a single tone CW signal according to the invention;

Figure 4     an adaptive IQ correction block as used according to the invention;

Figure 5     the TI-ADC interleaving mismatch spur bands for mismatch identification of a 2-channel and 4-channel TI-ADC. The upper diagram of the 4-channel TI-ADC shows the complete interleaving spectrum comprised of the ideal interleaved spectrum 302 and the interleaving spur groups 303, 304, 305. The four diagrams below show the ideal interleaved spectrum 302 and the individual spur groups 303, 304, 305 separately;

Figure 6     an M-channel TI-ADC mismatch correction according to the invention combined with an additional fixed filter.

**Detailed Description of preferred Embodiments of the Invention**

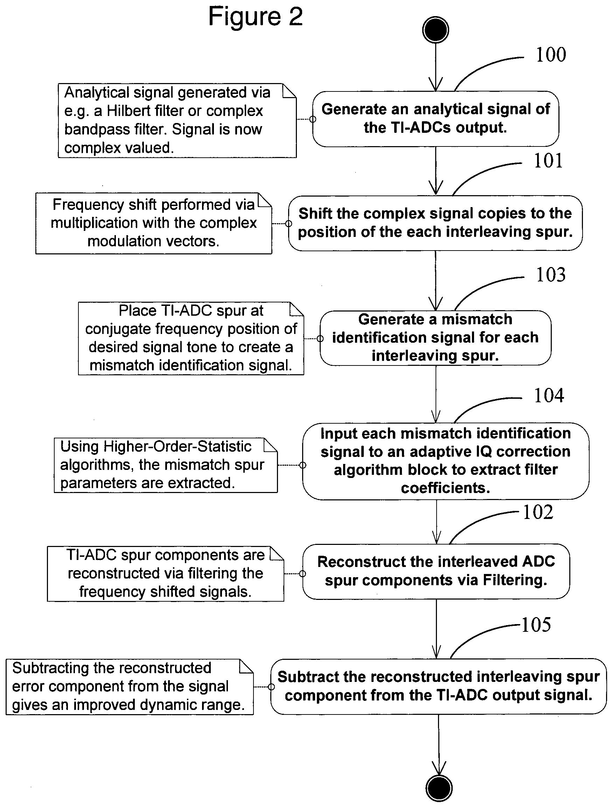

This invention mitigates the M-channel TI-ADC's mismatch related performance degradation (M being the number of ADCs operated in parallel during the time-interleaved analog to digital conversion). The block diagram of the invention is shown in Figure 1. The operations to be performed are also described in form of a flow chart as seen in Figure 2. The TI-ADC mismatch spurs are mitigated by reconstructing the spur components and subtracting them (in block 105) from the TI-ADC output signal $x_M(t)$. This increases the SFDR and restores the TI-ADC's lost effective resolution.

Block 100 is used to generate an analytical signal, e.g. via Hilbert transform or complex bandpass filtering. This creates a complex signal. For M number of interleaved ADCs, there exist M-1 spurs in the spectrum. E.g. for 4 TI-ADC (Figure 5) there is the ideal interleaved spectrum 302 and three interleaving spur groups 303, 304, 305. Therefore it is necessary to perform M-1 frequency shifts to move the signal to the spur frequency locations. This is performed in block 101. Once the signal has been shifted to the various interleaving spur locations, each frequency shifted signal has to be filtered as shown in block 102. After the filtering operation, the frequency shifted signals from block 102 have been manipulated in magnitude and in phase so that they correspond to the interleaving spur component. This step is done for each of the M-1 interleaving spurs.

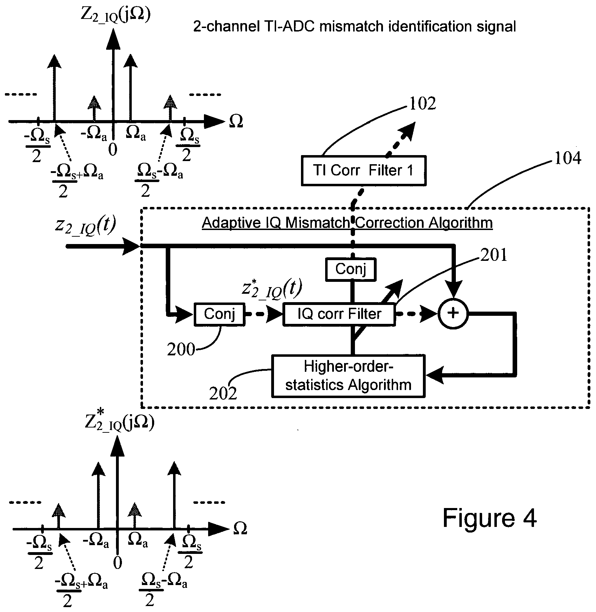

This invention adaptively finds the filtering coefficients for the block 102. This mismatch coefficient identification is done by block 104 using the output of block 103. Using the various frequency shifted components generated by block 101, mismatch identification signals (MIS) are produced in block 103. Each MIS produced is used for one specific interleaving mismatch spur identification. This is done by placing each spur on the conjugate frequency location of the desired signal tone (a concrete example for the spectrum of the MIS is illustrated in Figure 4). By doing so, the TI-ADC problem is mapped into an IQ imbalance problem. Now the well-known mismatch spur parameter extraction methods, used in IQ imbalance correction, become applicable.

The IQ imbalance correction is further explained with respect to Figure 4. A person familiar with IQ imbalance correction knows that the IQ imbalance correction involves taking the conjugate of the signal (at block 200), filtering it at IQ correction filter 201 and then subtracting it from the original signal. This reduces the spur level due to the IQ mismatch. Optimal scaling coefficients for the filter 201 are obtained in an adaptive manner e.g. by measuring (at block 202) statistical properties of the signal. Preferably, the above mentioned HOS algorithms can be applied which measure statistical properties within the signal that are lost when a spur is located at the conjugate frequency position of the desired signal tone.

The extracted mismatch parameters from filter 201 inside block 104 are fed into TI correction Filter 102 to filter the output signals from mixer 101. Then the reconstructed interleaving spur component is subtracted from the original signal $x_M(t)$ at 105, yielding the corrected signal $x_{M\_corr}(t)$ having a considerably reduced spur level.

As described above with respect to Figure 1, the TI-ADC mismatch spur correction can be done in parallel for all interleaving spur groups. In an alternative embodiment of the present invention the TI-ADC mismatch spur correction can be performed in a sequential manner for each interleaving spur group, for example by cascading the described TI-ADC mismatch correction algorithms. This means that e.g. spur group 304 of Figure 5 can be corrected first and independent of spur groups 303, 305.

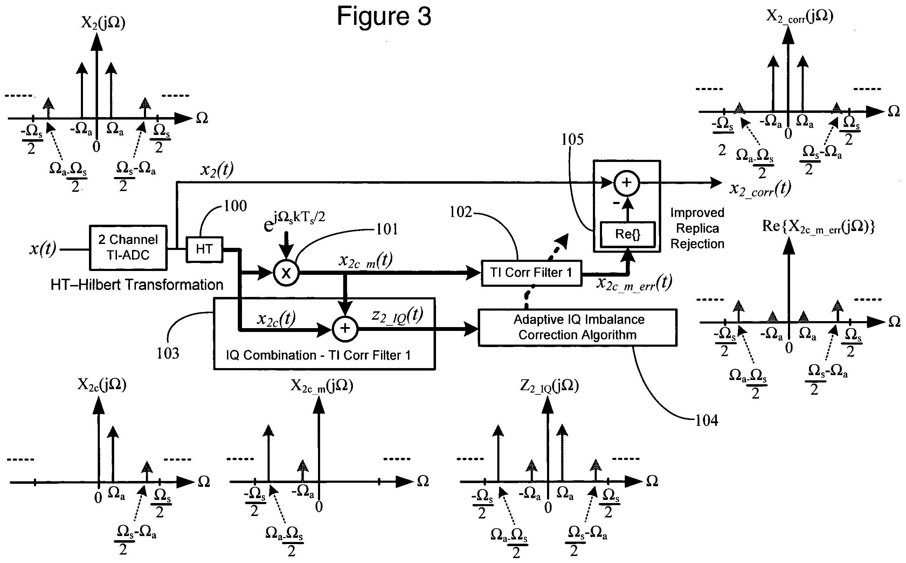

Using a 2-channel TI-ADC, a concrete example of the process according to the invention will be explained in detail. This is illustrated in Figure 3 in connection with Figure 4. To keep the illustration in Figure 3,4 simple, a single tone case is used when explaining the 2-channel TI-ADC mismatch correction process. Using a single tone scenario, it will be shown by example how the MIS is generated by placing the TI-ADC spur component at the conjugate frequency position of the desired signal tone (at block 103 of Figure 3. Simplified spectra of the various signals used in the process are shown as well. The shown two-sided frequency spectrum of input signal $x_2(t)$ (i.e. the TI-ADC output signal) comprises signal tones at signal frequency $+/-\Omega_a$ as well as spur components at frequencies $\Omega_s/2+/-\Omega_a$ ($\Omega_a=2\pi f_a$ with $f_a$ being the signal frequency, $\Omega_s=2\pi f_s$, $f_s$ being the sampling frequency and $T_s=1/f_s$).

Let an analytical signal $x_{2c}(t)$ be constructed using the output of a 2-channel TI-ADC $x_2(t)$ and its Hilbert Transform (generated in block 100 of Figure 3) as shown in eq. 1. The frequency response mismatch $h_{2.1}$ between the ADCs can be broken down into a gain (cf. magnitude) mismatch $A_\varepsilon$ and a phase mismatch $\varphi_\varepsilon$.

$$x_{2c}(t) = x_2(t) + j * HT\{x_2(t)\}$$
$$HT - \text{Hilbert Transform}$$
$$x_{2c}(t) = e^{j\Omega_a t} + h_{2.1}e^{j(\Omega_s/2-\Omega_a)t}$$
$$\text{with } h_{2.1} = (-A_\varepsilon/2 + j\varphi_\varepsilon/2)$$

eq. 1

Then $x_{2c}(t)$ is frequency shifted to the interleaving spur component location via multiplication with the modulation vector (at mixer 101) to produce $x_{2c\_m}(t)$ as shown in eq. 2.

$$x_{2c\_m}(t) = x_{2c}(t)e^{j(\Omega_s/2)t}$$
$$x_{2c\_m}(t) = e^{j(-\Omega_a+\Omega_s/2)t} + h_{2.1}e^{-j\Omega_a t}$$
$$\text{with } h_{2.1} = (-A_\varepsilon/2 + j\varphi_\varepsilon/2)$$

eq. 2

Then at block 103 for Figure 3 an IQ imbalance pair is created for the 2-channel TI-ADC spur identification by adding $x_{2c}(t)$ together with $x_{2c\_m}(t)$, producing $z_{2\_IQ}(t)$ as shown in eq. 3.

$$z_{2\_IQ}(t) = x_{2c}(t) + x_{2c\_m}(t) = \left(e^{j\Omega_a t} + h_{2.1}e^{j(\Omega_s/2-\Omega_a)t}\right) + \left(e^{j(-\Omega_s/2+\Omega_a)t} + h_{2.1}e^{-j\Omega_a t}\right)$$

$$z_{2\_IQ}(t) = \underbrace{e^{j\Omega_a t} + h_{2.1}e^{-j\Omega_a t}}_{IQ\,Pair\,1} + \underbrace{e^{j(-\Omega_s/2+\Omega_a)t} + h_{2.1}e^{j(\Omega_s/2-\Omega_a)t}}_{IQ\,Pair\,2}$$

$$\text{with } h_{2.1} = \left(-A_\varepsilon/2 + j\varphi_\varepsilon/2\right)$$

eq. 3

By adding $x_{2c}(t)$ and $x_{2c\_m}(t)$ (in block 103 of Figure 3), a MIS is created in the form of the signal $z_{2\_IQ}(t)$. The spectrum of $z_{2\_IQ}(t)$ is depicted in each of the Figures 3,4. It can be seen that each TI-ADC spur component is located at the conjugate frequency position of a desired signal tone. As outlined before each of the two created signal pairs can be viewed as an IQ imbalance signal pair on which well-known IQ mismatch correction algorithms can be applied, e.g. the HOS based adaptive algorithms. Therefore by using adaptive IQ imbalance compensation techniques (in block 104, Figure 4) on $z_{2\_IQ}(t)$, the gain and phase mismatch of the TI-ADCs can be extracted. A multiple tap version of the algorithm can be used to identify the frequency dependent TI-ADC mismatch and therefore extract the TI-ADC's frequency response mismatch.

The shifted frequencies $x_{2c\_m}(t)$ are then scaled with the factor $h^*_{2.1}$ to reconstruct the interleaving mismatch error component. These extracted mismatch values are used in the TI-ADC mismatch correction filter 102, which filters $x_{2c\_m}(t)$ to reconstruct the TI-ADC spur component $x_{2c\_m\_err}(t)$. Then the real part of reconstructed spur component $x_{2c\_m\_err}(t)$ is subtracted at block 105 from $x_2(t)$ to give $x_{2\_corr}(t)$. The signal $x_{2\_corr}(t)$ has a considerably reduced spur level.

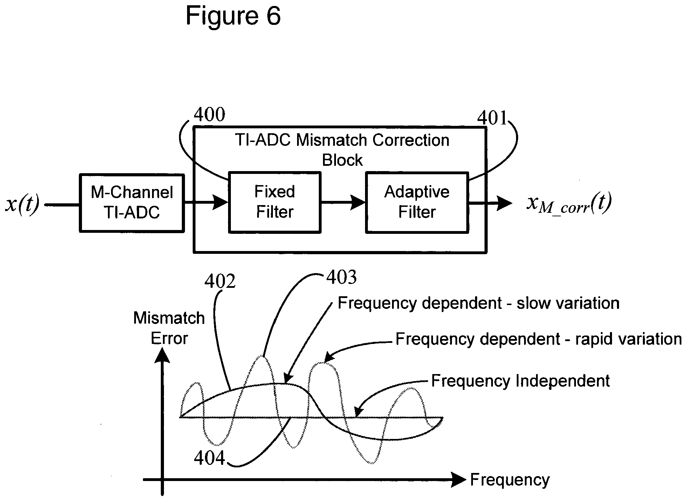

According to Figure 6, three types of mismatch curves are distinguished. In narrow band systems the mismatch is frequency independent (curve 404) or with a small frequency dependency (curve 402). Both types 402, 404 of mismatches can be corrected using the adaptive correction process according to the invention. Further, TI-ADCs with a large bandwidth can have rapidly changing variations in the frequency response mismatch as depicted in curve 403. An adaptive filter is not always suitable for following such rapidly changing variations. Therefore a fixed multitap correction filter can be advantageously foreseen to deal with these fast changing variations of curve 403 in the frequency response mismatch. Let this be known as a fixed filter 400. The fixed filter design may be done using pilot tones in the laboratory followed by determining the frequency response mismatch over the bandwidth and it can have an optimal number of filter taps required. Such fixed filter is then used in combination with the adaptive correction process described above which corrects slower changing variations (e.g. curve 402) resulting from TI-ADC's frequency response mismatches changes during operation due to various factors. The combination of a fixed filter 400 and an adaptive filter 401 is shown in Figure 6. It offers superior performance for TI-ADCs with a large bandwidth. It is particularly suitable for systems with high performance demand.

### Cited References

• Reference patents

Håkan Johansson, Per Löwenborg, Compensation Structure (US 8,009,070 B2), Timing Mismatch Identification (US 7,741,982 B2), Håkan Johansson - Compensation Structure (US 7,978,104 B2), Error Identification System (US 8,307,284 B2), Christian Vogel and Dieter Draxelmayr - Compensation Structure (US 7,403,875 B2).

• Reference Publications

[1] "A Review on Low-Complexity Structures and Algorithms for the Correction of Mismatch Errors in Time-Interleaved ADCs,", Christian Vogel, Matthias Hotz, Shahzad Saleem, Katharina Hausmair, and Michael Soudan, in Proceedings of the 10th IEEE International NEWCAS Conference, Montreal, Canada June 2012.

[2] "On blind identification of gain and timing mismatches in time-interleaved analog-to-digital converters", S. Saleem and C. Vogel, in 33rd International Conference on Telecommunications and Signal Processing, Baden (Austria), Aug 2010, pp. 151-155.

[3] "Adaptive blind background calibration of polynomial-represented frequency response mismatches in a two-channel time-interleaved ADC", S. Saleem and C. Vogel, IEEE Transactions on Circuits and Systems I: Regular Papers,, 2011.

[4] "LMS-based identification and compensation of timing mismatches in a two channel time-interleaved analog-to-digital converter", S. Saleem and C. Vogel, in Proceedings of the 25th IEEE Norchip Conference, Aalborg (Denmark), Nov. 2007.

[5] "Time-Interleaved Analog-to-Digital Converters: Status and Future Directions", Christian Vogel and Hakan Johansson, Proceedings of the 2006 IEEE International Symposium on Circuits and Systems (ISCAS 2006), Kos (Greece), 21-24 May 2006, pp. 3386-3389.

[6] "Circularity-Based I/Q Imbalance Compensation in Wideband Direct-Conversion Receivers", Anttila, L.; Valkama, M.; Renfors, M., Vehicular Technology, IEEE Transactions on , vol.57, no.4, pp.2099-2113, July 2008.

**Claims**

1. A process for mismatch correction of the output signal of a time-interleaved analog to digital converter, the output signal containing frequency components that include, besides a desired signal tone, one or more mismatch spur component groups, said process comprising:

   - generating (100) an analytical signal of the output signal of the time-interleaved analog to digital module, thereby creating a complex valued signal;
   - for each of the one or more mismatch spur component groups, frequency shifting (101) of the analytical signal in order to shift the desired signal tone to the frequency location of the corresponding mismatch spur component group by multiplication with a complex modulation vector, thereby generating corresponding shifted frequency components;
   - using the analytical signal and the shifted frequency components for creating (103) a mismatch identification signal for each mismatch spur component group by placing the corresponding mismatch spur component group at the conjugate frequency location of the desired signal tone,
   - subjecting (104) each mismatch identification signal to an IQ mismatch correction algorithm in order to derive mismatch spur parameters with respect to a mismatch spur component group,
   - filtering (102) the shifted frequency components by using the mismatch spur parameters derived via the IQ mismatch correction algorithm, thereby reconstructing the mismatch spur component group,
   - subtracting (105) the reconstructed mismatch spur component group from the output signal of the time-interleaved analog to digital module.

2. A process according to claim 1, wherein the mismatch correction of the output signal of the time-interleaved analog to digital module is performed in parallel with respect to a plurality of mismatch spur component groups.

3. A process according to claim 1, wherein the mismatch correction of the output signal of the time-interleaved analog to digital module is performed sequentially with respect to the individual mismatch spur component groups.

4. A process according to one of the foregoing claims 1 to 3, performed in combination with a further process for dealing with fast changing variations, said further process comprising filtering performed by a fixed filter.

**Patentansprüche**

1. Verfahren zur Übereinstimmungsfehlerkorrektur des Ausgangssignals eines zeitverschachtelten Analog-Digital-Wandlers, wobei das Ausgangssignal Frequenzkomponenten enthält, die neben einem gewünschten Signalton eine oder mehrere Übereinstimmungsfehler-Störkomponentengruppen aufweisen, wobei das Verfahren Folgendes aufweist:

   - Erzeugen (100) eines analytischen Signals des Ausgangssignals des zeitverschachtelten Analog-Digital-Moduls, wodurch ein komplexes Wertesignal erstellt wird,
   - für jede der einen oder mehreren Übereinstimmungsfehler-Störkomponentengruppen Frequenzverschieben (101) des analytischen Signals, um den gewünschten Signalton zu der Frequenzposition der entsprechenden Übereinstimmungsfehler-Störkomponentengruppe durch Multiplikation mit einem komplexen Modulationsvektor zu verschieben, wodurch entsprechende verschobene Frequenzkomponenten erzeugt werden,

- Verwenden des analytischen Signals und der verschobenen Frequenzkomponenten zum Erstellen (103) eines Übereinstimmungsfehler-Identifikationssignals für jede Übereinstimmungsfehler-Störkomponentengruppe durch Platzieren der entsprechenden Übereinstimmungsfehler-Störkomponentengruppe an der konjugierten Frequenzposition des gewünschten Signaltons,

- Unterziehen (104) jedes Übereinstimmungsfehler-Identifikationssignals einem IQ-Übereinstimmungsfehler-Korrekturalgorithmus, um Übereinstimmungsfehler-Störparameter in Bezug auf eine Übereinstimmungsfehler-Störkomponentengruppe abzuleiten,

- Filtern (102) der verschobenen Frequenzkomponenten unter Verwendung der Übereinstimmungsfehler-Störparameter, die über den IQ-Übereinstimmungsfehler-Korrekturalgorithmus abgeleitet werden, wodurch die Übereinstimmungsfehler-Störkomponentengruppe rekonstruiert wird,

- Subtrahieren (105) der rekonstruierten Übereinstimmungsfehler-Störkomponentengruppe von dem Ausgangssignal des zeitverschachtelten Analog-Digital-Moduls.

2. Verfahren nach Anspruch 1, wobei die Übereinstimmungsfehlerkorrektur des Ausgangssignals des zeitverschachtelten Analog-Digital-Moduls parallel in Bezug auf mehrere Übereinstimmungsfehler-Störkomponentengruppen durchgeführt wird.

3. Verfahren nach Anspruch 1, wobei die Übereinstimmungsfehlerkorrektur des Ausgangssignals des zeitverschachtelten Analog-Digital-Moduls aufeinanderfolgend in Bezug auf die einzelnen Übereinstimmungsfehler-Störkomponentengruppen durchgeführt wird.

4. Verfahren nach einem der vorhergehenden Ansprüche 1 bis 3, das in Kombination mit einem weiteren Verfahren zum Handhaben von sich schnell verändernden Variationen durchgeführt wird, wobei das weitere Verfahren ein Filtern aufweist, das durch einen festen Filter durchgeführt wird.

## Revendications

1. Procédé de correction de désadaptation du signal de sortie d'un convertisseur analogique-numérique à entrelacement temporel, le signal de sortie contenant des composants de fréquence qui comprennent, en plus d'une tonalité de signal souhaitée, un ou plusieurs groupes de composants parasites de désadaptation, ledit procédé consistant :

- à générer (100) un signal analytique du signal de sortie du module analogique-numérique à entrelacement temporel, ce qui permet de créer un signal à valeur complexe ;

- pour le groupe de composants parasites de désadaptation ou pour chacun des groupes de composants parasites de désadaptation, à décaler (101) la fréquence du signal analytique afin de passer la tonalité de signal souhaitée à l'emplacement de fréquence du groupe de composants parasites de désadaptation correspondant par multiplication avec un vecteur de modulation complexe, ce qui permet de générer des composants de fréquence décalée correspondants ;

- à utiliser le signal analytique et les composants de fréquence décalée pour créer (103) un signal d'identification de désadaptation pour chaque groupe de composants parasites de désadaptation en plaçant le groupe de composants parasites de désadaptation correspondant à l'emplacement de fréquence conjugué de la tonalité de signal souhaitée,

- à soumettre (104) chaque signal d'identification de désadaptation à un algorithme de correction de désadaptation IQ afin de dériver des paramètres parasites de désadaptation par rapport à un groupe de composants parasites de désadaptation,

- à filtrer (102) les composants de fréquence décalée en utilisant les paramètres parasites de désadaptation dérivés par le biais de l'algorithme de correction de désadaptation IQ, ce qui permet de reconstruire le groupe de composants parasites de désadaptation,

- à soustraire (105) le groupe de composants parasites de désadaptation reconstruit du signal de sortie du module analogique-numérique à entrelacement temporel.

2. Procédé selon la revendication 1, dans lequel la correction de désadaptation du signal de sortie du module analogique-numérique à entrelacement temporel est réalisée en parallèle par rapport à une pluralité de groupes de composants parasites de désadaptation.

3. Procédé selon la revendication 1, dans lequel la correction de désadaptation du signal de sortie du module analogique-numérique à entrelacement temporel est réalisée de manière séquentielle par rapport aux groupes de composants parasites de désadaptation individuels.

4. Procédé selon l'une des revendications précédentes 1 à 3, réalisé en combinaison avec un autre procédé pour traiter des variations changeant rapidement, ledit autre procédé comprenant un filtrage réalisé par un filtre fixe.

Figure 1

# Figure 2

● ⟋ 100

┌─────────────────────────────────┐
│ Generate an analytical signal of │
│ the TI-ADCs output.             │
└─────────────────────────────────┘

┌──────────────────────────────────────┐
│ Analytical signal generated via      │
│ e.g. a Hilbert filter or complex     │
│ bandpass filter. Signal is now       │
│ complex valued.                      │
└──────────────────────────────────────┘

⟋ 101

┌──────────────────────────────────────┐
│ Shift the complex signal copies to the│
│ position of the each interleaving spur.│
└──────────────────────────────────────┘

┌──────────────────────────────────────┐
│ Frequency shift performed via        │
│ multiplication with the complex      │
│ modulation vectors.                  │
└──────────────────────────────────────┘

⟋ 103

┌────────────────────────────┐
│ Generate a mismatch        │
│ identification signal for each│
│ interleaving spur.         │
└────────────────────────────┘

┌──────────────────────────────────────┐
│ Place TI-ADC spur at                 │
│ conjugate frequency position of      │
│ desired signal tone to create a      │
│ mismatch identification signal.      │
└──────────────────────────────────────┘

⟋ 104

┌──────────────────────────────────┐
│ Input each mismatch identification│
│ signal to an adaptive IQ correction│
│ algorithm block to extract filter │
│ coefficients.                     │
└──────────────────────────────────┘

┌──────────────────────────────────────┐
│ Using Higher-Order-Statistic         │
│ algorithms, the mismatch spur        │
│ parameters are extracted.            │
└──────────────────────────────────────┘

⟋ 102

┌──────────────────────────────┐
│ Reconstruct the interleaved ADC│
│ spur components via Filtering. │
└──────────────────────────────┘

┌──────────────────────────────────────┐
│ TI-ADC spur components are           │
│ reconstructed via filtering the      │
│ frequency shifted signals.           │
└──────────────────────────────────────┘

⟋ 105

┌──────────────────────────────────────┐
│ Subtract the reconstructed interleaving spur│
│ component from the TI-ADC output signal.│
└──────────────────────────────────────┘

┌──────────────────────────────────────┐
│ Subtracting the reconstructed        │
│ error component from the signal      │
│ gives an improved dynamic range.     │
└──────────────────────────────────────┘

●

# Figure 3

$X_2(j\Omega)$

$X_{2\_corr}(j\Omega)$

$\dfrac{\Omega_a-\Omega_s}{2}$   $\dfrac{\Omega_s-\Omega_a}{2}$

105

$x_2(t)$

$x_{2\_corr}(t)$

Improved Replica Rejection

$x(t)$ → 2 Channel TI-ADC → HT

HT–Hilbert Transformation

100

$e^{j\Omega_s kT_s/2}$   101

$x_{2c\_m}(t)$

TI Corr Filter 1

102

Re{}

$x_{2c\_m\_err}(t)$

$Re\{X_{2c\_m\_err}(j\Omega)\}$

103   $x_{2c}(t)$   $z_{2\_IQ}(t)$

IQ Combination - TI Corr Filter 1

Adaptive IQ Imbalance Correction Algorithm

104

$\dfrac{\Omega_a-\Omega_s}{2}$   $\dfrac{\Omega_s-\Omega_a}{2}$

$X_{2c}(j\Omega)$

$X_{2c\_m}(j\Omega)$

$Z_{2\_IQ}(j\Omega)$

$\dfrac{\Omega_s-\Omega_a}{2}$

$\dfrac{\Omega_a-\Omega_s}{2}$

$\dfrac{\Omega_a-\Omega_s}{2}$   $\dfrac{\Omega_s-\Omega_a}{2}$

EP 2 773 045 B1

2-channel TI-ADC mismatch identification signal

Figure 4

## 2-channel TI-ADC

$X_2(j\Omega)_{interleaved}$    300    $\Omega_s = 2*\Omega_{ADC}$

IMSB

BoU

$-\dfrac{5\Omega_s}{2}$   $-2\Omega_s$   $-\dfrac{3\Omega_s}{2}$   $-\Omega_s$   $-\dfrac{\Omega_s}{2}$   0   $\dfrac{\Omega_s}{2}$   $\Omega_s$   $\dfrac{3\Omega_s}{2}$   $2\Omega_s$   $\Omega$

IMSB-Interleaving Mismatch Spur Band
BoU-Band of Use

## 4-channel TI-ADC

$X_4(j\Omega)_{interleaved}$    $\Omega_s = 4*\Omega_{ADC}$

IMSB   301

BoU

$-\dfrac{5\Omega_s}{4}$   $-\Omega_s$   $-\dfrac{3\Omega_s}{4}$   $-\dfrac{\Omega_s}{2}$   $-\dfrac{\Omega_s}{4}$   0   $\dfrac{\Omega_s}{4}$   $\dfrac{\Omega_s}{2}$   $\dfrac{3\Omega_s}{4}$   $\Omega_s$   $\Omega$

=

302    Ideal Interleaved Spectrum

$-\dfrac{5\Omega_s}{4}$   $-\Omega_s$   $-\dfrac{3\Omega_s}{4}$   $-\dfrac{\Omega_s}{2}$   $-\dfrac{\Omega_s}{4}$   0   $\dfrac{\Omega_s}{4}$   $\dfrac{\Omega_s}{2}$   $\dfrac{3\Omega_s}{4}$   $\Omega_s$   $\Omega$

+

303    $h_{4.1}$   Interleaving Spur Group 1

$-\dfrac{5\Omega_s}{4}$   $-\Omega_s$   $-\dfrac{3\Omega_s}{4}$   $-\dfrac{\Omega_s}{2}$   $-\dfrac{\Omega_s}{4}$   0   $\dfrac{\Omega_s}{4}$   $\dfrac{\Omega_s}{2}$   $\dfrac{3\Omega_s}{4}$   $\Omega_s$   $\Omega$

+

304    $h_{4.2}$   Interleaving Spur Group 2

$-\dfrac{5\Omega_s}{4}$   $-\Omega_s$   $-\dfrac{3\Omega_s}{4}$   $-\dfrac{\Omega_s}{2}$   $-\dfrac{\Omega_s}{4}$   0   $\dfrac{\Omega_s}{4}$   $\dfrac{\Omega_s}{2}$   $\dfrac{3\Omega_s}{4}$   $\Omega_s$   $\Omega$

+

$h_{4.3}$   305    Interleaving Spur Group 3

$-\dfrac{5\Omega_s}{4}$   $-\Omega_s$   $-\dfrac{3\Omega_s}{4}$   $-\dfrac{\Omega_s}{2}$   $-\dfrac{\Omega_s}{4}$   0   $\dfrac{\Omega_s}{4}$   $\dfrac{\Omega_s}{2}$   $\dfrac{3\Omega_s}{4}$   $\Omega_s$   $\Omega$

## Figure 5

Figure 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7403875 B2
- US 8307284 B2
- US 7741982 B2
- US 7978104 B2
- US 8009070 B2

### Non-patent literature cited in the description

- **S. M. JAMAL ; D. FU ; N. C. J. CHANG ; P. J. HURST ; S. H. LEWIS.** A 10-b 120-Msample/s timeinterleaved analog-to-digital converter with digital background calibration. *IEEE J. Solid-State Circuits,* 2002, vol. 37 (12), 1618-1627
- **JAMAL, S.M. ; FU, D. ; SINGH, M.P. ; HURST, P.J. ; LEWIS, S.H.** Calibration of Sample-Time Error in a Two-Channel Time-Interleaved Analog-to-Digital Converter. *IEEE Transactions on Circuits and Systems, I Fundamental Theory and Applications,* 2004, vol. 51 (1), 130
- **C. H. LAW ; P. J. HURST ; S. H. LEWIS.** A four-channel time-interleaved ADC with digital calibration of interchannel timing and memory errors. *IEEE J. Solid-State Circuits,* 2010, vol. 45 (10), 2091-2103
- **CHRISTIAN VOGEL ; MATTHIAS HOTZ ; SHAHZAD SALEEM ; KATHARINA HAUSMAIR ; MICHAEL SOUDAN.** A Review on Low-Complexity Structures and Algorithms for the Correction of Mismatch Errors in Time-Interleaved ADCs. *Proceedings of the 10th IEEE International NEWCAS Conference,* June 2012
- **S. SALEEM ; C. VOGEL.** On blind identification of gain and timing mismatches in time-interleaved analog-to-digital converters. *33rd International Conference on Telecommunications and Signal Processing,* August 2010, 151-155
- **S. SALEEM ; C. VOGEL.** Adaptive blind background calibration of polynomial-represented frequency response mismatches in a two-channel time-interleaved ADC. *IEEE Transactions on Circuits and Systems I: Regular Papers,* 2011
- **S. SALEEM ; C. VOGEL.** LMS-based identification and compensation of timing mismatches in a two channel time-interleaved analog-to-digital converter. *Proceedings of the 25th IEEE Norchip Conference,* November 2007
- **CHRISTIAN VOGEL ; HAKAN JOHANSSON.** Time-Interleaved Analog-to-Digital Converters: Status and Future Directions. *Proceedings of the 2006 IEEE International Symposium on Circuits and Systems (ISCAS 2006),* 21 May 2006, 3386-3389
- **ANTTILA, L. ; VALKAMA, M. ; RENFORS, M.** Circularity-Based I/Q Imbalance Compensation in Wideband Direct-Conversion Receivers. *Vehicular Technology, IEEE Transactions,* July 2008, vol. 57 (4), 2099-2113